(19) Europäisches Patentamt
European Patent Office
Office européen des brevets

(11) **EP 4 207 256 A1**

(12) **EUROPEAN PATENT APPLICATION**
published in accordance with Art. 153(4) EPC

(43) Date of publication:
**05.07.2023 Bulletin 2023/27**

(21) Application number: **21861559.9**

(22) Date of filing: **24.08.2021**

(51) International Patent Classification (IPC):
***H01L 21/60*** *(2006.01)*

(52) Cooperative Patent Classification (CPC):
(C-Sets available)
**H01L 24/45; H01L 21/60; H01L 24/43;** H01L 24/05;
H01L 24/48; H01L 24/85; H01L 2224/05624;
H01L 2224/43848; H01L 2224/45014;
H01L 2224/45016; H01L 2224/45124;
H01L 2224/45147; H01L 2224/48247;
H01L 2224/84555; H01L 2924/15747 (Cont.)

(86) International application number:
**PCT/JP2021/030994**

(87) International publication number:
**WO 2022/045134 (03.03.2022 Gazette 2022/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.08.2020 JP 2020145886**

(71) Applicants:
- **Nippon Micrometal Corporation
  Iruma-shi
  Saitama 358-0032 (JP)**
- **NIPPON STEEL Chemical & Material Co., Ltd.
  Tokyo 103-0027 (JP)**

(72) Inventors:
- **UNO, Tomohiro
  Tokyo 100-8071 (JP)**
- **OYAMADA, Tetsuya
  Tokyo 100-8071 (JP)**
- **SUTO, Yuya
  Tokyo 100-8071 (JP)**
- **ODA, Daizo
  Iruma-shi, Saitama 358-0032 (JP)**
- **KURIHARA, Yuto
  Iruma-shi, Saitama 358-0032 (JP)**
- **OISHI, Ryo
  Iruma-shi, Saitama 358-0032 (JP)**

(74) Representative: **Vossius & Partner
Patentanwälte Rechtsanwälte mbB
Siebertstraße 3
81675 München (DE)**

(54) **ALUMINUM WIRING MATERIAL**

(57) There is provided a novel Al wiring material that achieves a favorable high-temperature reliability as well as a favorable workability and bondability during installation and connection to a device. The Al wiring material contains Mg and Si so as to satisfy $0.05 \leq x1a \leq 2.5$, $0.02 \leq x1b \leq 1$, and $0.1 \leq (x1a + x1b) \leq 3$ where $x1a$ is a content of Mg [% by mass] and $x1b$ is a content of Si [% by mass], and contains one or more selected from the group consisting of Sc, Er, Yb, Gd, Ce and Y so as to satisfy $0.001 \leq x2 \leq 0.5$ where $x2$ is a total content thereof [% by mass], with the balance comprising Al.

EP 4 207 256 A1

(52) Cooperative Patent Classification (CPC): (Cont.)

C-Sets
H01L 2224/05624, H01L 2924/01029;
H01L 2224/45124, H01L 2924/01012;
H01L 2224/45124, H01L 2924/01014;
H01L 2224/45124, H01L 2924/01021;
H01L 2224/45124, H01L 2924/01025;
H01L 2224/45124, H01L 2924/01028;
H01L 2224/45124, H01L 2924/01029;
H01L 2224/45124, H01L 2924/0103;
H01L 2224/45124, H01L 2924/01039;
H01L 2224/45124, H01L 2924/0104;
H01L 2224/45124, H01L 2924/01058;
H01L 2224/45124, H01L 2924/01064;
H01L 2224/45124, H01L 2924/01068;
H01L 2224/45124, H01L 2924/0107;
H01L 2224/45124, H01L 2924/01205;
H01L 2224/45147, H01L 2924/00015;
H01L 2224/84555, H01L 2924/00014

**Description**

**TECHNICAL FIELD**

The present invention relates to an Al wiring material. The present invention further relates to a semiconductor device including the Al wiring material.

**BACKGROUND ART**

As for a linear material used for electrical connection and/or mechanical connection in industrial devices and electronic parts, the use of aluminum (Al) is increasing with a demand of computerization of automobiles since aluminum is more lightweight and inexpensive than copper (Cu) which has been conventionally used. For an Al wire (circle) and an Al strip (flat or ellipse) used for industrial devices such as a conveying device and a robot, there are required mechanical properties such as a breaking strength and an elongation, an electrical conductivity, a thermal conductivity, and the like depending on the purposes of use.

In a semiconductor device, electrodes formed on a semiconductor element are connected with a lead frame or electrodes on a circuit board (hereinafter also referred to as "substrate") using a bonding wire or a bonding ribbon. In a power semiconductor device, Al is mainly used for the bonding wire or bonding ribbon. For example, Patent Literature 1 discloses an example of using an Al bonding wire with a diameter of 300 $\mu$m in a power semiconductor module. In the power semiconductor device using the Al bonding wire or Al bonding ribbon, wedge bonding is used as a bonding process for both of first connection with electrodes on a semiconductor chip and second connection with the lead frame or electrodes on a substrate.

Hereinafter, the above-described Al wire, Al strip, Al bonding wire, Al bonding ribbon, and the like are collectively referred to as an Al wiring material.

Power semiconductor devices using Al wiring materials are often used as semiconductor devices for large power equipment such as air conditioners and photovoltaic power generation systems, and on-vehicle semiconductor devices. In these semiconductor devices, the connected part between the wiring material and a member to be connected is exposed to a high temperature of 140°C or more during operation of the devices. Further, when the semiconductor devices operate by switching high voltage on and off at high speed, it is exposed a severe environment where the temperature is repetitively increased and decreased. When using a material composed only of high purity Al as the wiring material, softening of the wiring material tends to proceed in such a temperature environment at the time when the device operates, and it is difficult to use such wiring material in a high temperature environment.

There has been developed an Al wiring material made of a material obtained by adding a specific element to Al. For example, Patent Literature 2 discloses an Al bonding wire the mechanical strength of which is improved by adding scandium (Sc) of 0.05 to 1 % by weight to Al to be precipitation-hardened. Patent Literature 3 discloses an Al bonding wire in which 0.15 to 0.5% by mass of Sc is added to Al and forcibly caused to be solid solution, where the wire is precipitation-hardened by an aging heat treatment after connection. Patent Literature 4 discloses that an Al wiring material containing one or more of nickel (Ni), silicon (Si), and phosphorus (P), the amount of which is 800 ppm by mass or less in total, has favorable bonding strength and weather resistance. Patent Literature 5 discloses that an Al wiring material containing magnesium (Mg) and Si in a total content of 0.03 wt% or more and 0.3 wt% or less improves the reliability of the connection parts.

**RELATED ART REFERENCE**

**Patent Literature**

Patent Literature 1: JP-A-2002-314038
Patent Literature 2: JP-A-2016-511529
Patent Literature 3: JP-A-2014-47417
Patent Literature 4: JP-A-2016-152316
Patent Literature 5: JP-B-6272674

## SUMMARY OF INVENTION

## PROBLEM TO BE SOLVED BY THE INVENTION

With enhancement of functions of industrial devices and electronic parts and with expansion of application thereof, a requirement for Al wiring materials used therefor becomes higher. For an Al wiring material used for industrial devices such as a conveying device and a robot, it is required an adaptability to a high-temperature environment or repetitive bending deformation. Recently, during use in a high-temperature environment in automotive applications, the strength of the wire deteriorates to cause an inferior deformation or cracks which may lead to disconnection. Therefore, it is required to suppress a decrease in strength of the Al wiring material in a high-temperature environment to improve a high-temperature reliability. However, when the strength of the wiring material is merely increased, it is difficult to achieve a sufficient high-temperature reliability, and also, there are concerns that the wiring material deteriorates in workability, bondability, and the like during installation and use thereof.

For an Al wiring material used for electronic parts such as a semiconductor, owing to expansion of application of automotive power devices, it is required to improve the initial bondability and the high-temperature reliability of the connection part. In a semiconductor, the Al wiring material is used for two connections including the connection with electrodes on a semiconductor chip (hereinafter referred to as "first connection") and the connection with the lead frame or external electrodes on a substrate (hereinafter referred to as "second connection"). In power devices, an impulsive thermal stress may be caused in accordance with a temperature change during operation of the devices (hereinafter referred to as "thermal shock"), and the first connection part which is the connection part between the Al wiring material and the electrode on the semiconductor chip may be damaged. Specifically, due to a difference between coefficients of thermal expansion of the Al wiring material and the member to be connected, a crack may be caused at an interface of the connection part (hereinafter referred to as "bond crack"). Also, due to a bending stress caused by expansion and contraction of the Al wiring material itself, a crack may be caused at a loop rising part in the vicinity of the connection part (hereinafter referred to as "heel crack"). The bond crack or the heel crack develops with corrosion in an environment at the time when the device operates, and the Al wiring material finally comes off from the member to be connected. Thus, the high-temperature reliability of the connection part is deteriorated. Herein, a power cycle test is performed as one of accelerating test methods of thermal shock. This test repeats rapid heating and cooling by turning the voltage on and off repeatedly. When the bonding strength of the connection part with a member to be connected is reduced or deteriorates due to the thermal shock, there arise problems that cracks develop in the vicinity of the connecting interface to cause peeling-off, and the like. In this regard, there is a method of adding other element(s) to the Al wiring material to suppress the coarsening of crystal grains, and increasing the strength of the Al wiring material. However, in such a method, as the content of these elements in the Al wiring material increases, a yield may be lowered because the wire breakage or damage occurs at the time of manufacturing the Al wiring material, or a member to be connected may be damaged at the time of connecting the Al wiring material to the member to be connected (hereinafter referred to as "chip damage").

In addition, it is difficult to achieve and improve the long-time reliability of the connection part in a high-temperature environment which is required for a power device for high temperature, such as SiC. For example, with regard to the endurance in the power cycle test, a failure such as bond crack occurs in the connection part of the Al wiring material under a severe condition of more than 10,000 cycles. Due to this, the power device is not put in practical use.

For the Al wiring material in which the other elements are added, the performance thereof is improved by using a solid solution, precipitation, and the like, and a heat treatment during the production of the Al wiring material or a heat treatment after the connection of the Al wiring material is performed. In order to enhance the high-temperature reliability described above, it is necessary to perform the heat treatment at a higher temperature or for a longer time than a conventional Al wiring material product. This leads to problems such as a deterioration of bondability, a decrease in productivity, an increase in production cost, and a thermal influence on the member to be connected (e.g., a substrate and a peripheral member) of the Al wiring material. Therefore, there is required an Al wiring material that can improve the high-temperature reliability even when performing the heat treatment at a low-temperature or for a short-time.

A technique for improving the high-temperature reliability of the Al wiring material has been investigated so far. For example, it is known that for an Al wiring material containing Mg or Si, the high-temperature reliability is improved (Patent Literatures 4 and 5). However, the effect of improvement is small, and thus such an Al wiring material has not been put in practical use, yet. In a severe power cycle test, the high-temperature reliability may be improved when the cycle number is low. However, when the cycle number is increased, a failure such as a crack occurs in the connection part. Further, it is known that also for an Al wiring material containing Sc, the high-temperature reliability is improved (Patent Literatures 2 and 3). However, there is a problem that since the heat treatment during production needs to be performed at a high temperature in order to improve the high-temperature reliability, an appropriate range of heat treatment condition is limited and control thereof is difficult. In addition, the heat treatment after the connection needs to be performed at a high temperature for a relatively long time. These prevents practical utilization.

With regard to the heat treatment during the production of the wiring material or the heat treatment after the connection of the wiring material, if the reliability of the connection part and the bondability can be improved by a low-temperature or short-time treatment, the quality and reliability during use in a high-temperature environment can be improved, and thus, there contributes to an improvement in the function, the quality, and the reliability of automotive electronic parts, power semiconductor devices, and the like.

An object of the present invention is to provide a novel Al wiring material that achieves a favorable high-temperature reliability as well as a favorable workability and bondability during installation and connection to a device.

**MEANS FOR SOLVING PROBLEM**

As a result of earnest investigation as to the problem described above, the present inventors have found that the problem described above can be solved by the Al wiring material having the configuration described below, and further investigated the problem based on such knowledge to complete the present invention.

Specifically, the present invention includes the following.

[1] An Al wiring material containing Mg and Si so as to satisfy

$$0.05 \leq x1a \leq 2.5,$$

$$0.02 \leq x1b \leq 1,$$

and

$$0.1 \leq (x1a + x1b) \leq 3$$

where x1a is a content of Mg [% by mass] and x1b is a content of Si [% by mass],
and containing one or more selected from the group consisting of Sc, Er, Yb, Gd, Ce and Y so as to satisfy

$$0.001 \leq x2 \leq 0.5$$

where x2 is a total content thereof [% by mass], with the balance comprising Al.

[2] The Al wiring material according to [1], further containing one or more selected from the group consisting of Zr, Fe, Ni, Mn, Cu and Zn so as to satisfy

$$0.01 \leq x3 \leq 0.5$$

where x3 is a total content thereof [% by mass].
[3] The Al wiring material according to [1] or [2], wherein the Al wiring material is a bonding wire.
[4] A semiconductor device comprising the Al wiring material according to any one of [1] to [3].

**EFFECT OF THE INVENTION**

The present invention can provide a novel Al wiring material that achieves a favorable high-temperature reliability as well as a favorable workability and bondability during installation and connection to a device. The novel Al wiring material can enhance the workability and bondability during installation and connection to a device, and productivity. The novel Al wiring material can also exhibit a favorable high-temperature reliability when performing a low-temperature or short-time treatment for the heat treatment during the production of the wiring material or the heat treatment after the connection or without requiring the heat treatment.

**EMBODIMENT FOR CARRYING OUT THE INVENTION**

Hereinafter, the present invention will be described in detail with reference to preferable embodiments thereof.

[Al Wiring Material]

The Al wiring material of the present invention contains Mg and Si so as to satisfy $0.05 \leq x1a \leq 2.5$, $0.02 \leq x1b \leq 1$, and $0.1 \leq (x1a + x1b) \leq 3$ where $x1a$ is a content of Mg [% by mass] and $x1b$ is a content of Si [% by mass]. The Al wiring material of the present invention further contains one or more selected from the group consisting of Sc, Er, Yb, Gd, Ce and Y so as to satisfy $0.001 \leq x2 \leq 0.5$ where $x2$ is a total content thereof [% by mass].

By adding Mg and Si (hereinafter referred to as "first group element") and further adding one or more selected from the group consisting of Sc, Er, Yb, Gd, Ce and Y (hereinafter referred to as "second group element") into the Al wiring material, it is possible to enhance the high-temperature reliability of the Al wiring material even when a heat treatment during the production of the Al wiring material or a heat treatment after the connection of the Al wiring material is performed at a low temperature or in a short time. Moreover, it is possible to enhance ordinary-temperature properties such as the workability and the bondability during installation and connection to a member to be connected. When the high-temperature reliability and the ordinary-temperature properties are simultaneously satisfied, the high-temperature reliability can be improved and enhanced during use of the Al wiring material for automotive electronic parts and high-power electronic apparatuses such as power semiconductor devices. Further, for the Al wiring material in which the first group element and the second group element are added in combination, it is possible to decrease an unbonded area in which a metal junction is insufficient in a connection interface where the Al wiring material is connected to a member to be connected (for example, an Al electrode) at an ordinary temperature, and there can be achieved excellent effects such as an increase in the bonding strength and a decrease in the peeling-off of the connection part during mass production. Furthermore, the high-temperature reliability of the connection part can be improved when subjected to a thermal history in which a high temperature and a low temperature are repeated during high-power operation of an electronic device. For example, in a power cycle test that is an acceleration test for evaluating the high-temperature reliability, a decrease in the bonding strength can be suppressed, or an occurrence of a crack in the connection part can be suppressed.

When containing Mg and Si, a solid solution and an Mg-Si based compound are formed in Al even when the temperature of the heat treatment during the production of the Al wiring material or the heat treatment after the connection of the Al wiring material is low. As a result, there can be achieved an effect of suppressing the progress of recovery and recrystallization in a high-temperature environment. When further containing one or more selected from the group consisting of Sc, Er, Yb, Gd, Ce and Y, the effect of suppressing recrystallization can be held at a higher temperature or for a longer time, and thus the excellent high-temperature reliability can be achieved. Even when the power cycle test applying a high voltage is performed under a severe condition of more than 10,000 cycles, a failure such as occurrence of a crack due to coarsening of recrystallized grains in the connection part of the Al wiring material can be decreased, and the high bonding strength can be maintained. By optimizing the types, the added amounts, and the like of the first group element and the second group element, it is even possible to achieve the bonding strength in a high-temperature environment that is higher than the initial bonding strength.

Although a factor that exerts such improvement effects is unclear, it is considered that a Mg-Si based compound, precipitate and/or intermediate phase are/is produced by a low-temperature heat treatment, and then the elements of Sc, Er, Yb, Gd, Ce and Y are aggregated around the products, or the elements of Sc, Er, Yb, Gd, Ce and Y are reacted with Al to form precipitates ($Al_3Sc$, $Al_3Er$, $Al_aYb$, etc.). It is considered that since the additive elements act compositely as described above, dislocations and migration of grain boundaries in the Al wiring material can be suppressed in a high-temperature environment so as to maintain or increase the strength, or the particle growth of the recrystallized grain can be suppressed so as to make the grain finer.

The Al wiring material of the present invention containing both the first group element and the second group element is excellent also in that the bondability can be improved during connection to the member to be connected. Specifically, according to the Al wiring material, there can be increased an effective bond area ratio R that corresponds to the ratio of a region where a metal junction is achieved in the connection interface. As a consequence, the bonding strength can be enhanced even under a condition in which a load and an ultrasonic wave vibration during the connection are weak. This is effective for a decrease in chip damage and the like. Although the bondability can be evaluated substantially in terms of the bonding strength measured in a shear measurement method, the evaluation of the value R is effective to more accurately grasp a state of the connection interface. Herein, the effective bond area ratio R is determined as the ratio (M2/M1) of an achieved metal junction M2 relative to a bond area M1. For example, the effective bond area ratio R of the connection part between the Al wiring material and an electrode on a semiconductor chip can be determined by the following procedure. First, a shear test of the connection part is performed, and the fractured bonded part is observed with an optical microscope or a SEM. By image analysis, the bond area M1 and an area of unbonded part M3 are determined, and the achieved metal junction M2 (= M1 - M3) is calculated. Here, the area of unbonded part M3 is an area of a region which is determined that the electrode is deformed at the time of bonding but metal junction is not achieved. The value R can be calculated as the ratio (M2/M1) of M2 to M1. The equation for the calculation is, for example, R = M2/M1 = (M1 - M3)/M1. It has been found that as the value R is higher, the bondability is better. It has been also found that as the value R is higher, it is more effective to improve the high-temperature reliability.

When merely containing Mg and Si (first group element), the reliability in a high-temperature environment may be maintained for a short time, but the reliability rather deteriorates with the passage of long time. This is a problem. When merely containing Sc, Er, Yb, Gd, Ce and Y (second group element), a high-temperature heat treatment is required to improve the high-temperature reliability and thus there arises a problem that the bondability of the Al wiring material deteriorates. Further, when the Al wiring material is subjected to the heat treatment after the connection, the heat treatment needs to be performed at a relatively high temperature for a long time. Therefore, there is a concern about an influence on a peripheral material as described above.

In contrast, when using the first group element and the second group element in combination to coexist them, it has been confirmed that a high effect of improving the high-temperature reliability and the bondability is obtained even when the temperature of the heat treatment during the production of the Al wiring material is decreased or the temperature of the heat treatment after the connection is decreased. There will be described an example in terms of the comparison of the high-temperature reliability when the temperature of a post-bonding heat treatment after the connection is low. After the post-bonding heat treatment was performed for a power semiconductor device that was bonded to an Al electrode under a condition of a low temperature and a short time, that is, at 200 to 300°C for 10 minutes to 2 hours, the power cycle test was performed for evaluation. For the Al wiring material in which the first group element and the second group element were added in combination, a high bonding strength was maintained until 50,000 cycles and 100,000 cycles, and favorable results were obtained. On the other hand, for an Al wiring material in which the first group element was added solely, a favorable bonding strength was exhibited until 50,000 cycles in some cases, but a decrease in strength was significant at 100,000 cycles. For an Al wiring material in which the second group element was added solely, a decrease in strength had been confirmed at 50,000 cycles.

The second group element, i.e., Sc, Er, Yb, Gd, Ce and Y can similarly exhibit the addition effect described above. Furthermore, the characteristics of each element can be utilized to achieve optimization according to requirements. For example, with regard to Sc, it increases the strength in a high-temperature environment, and thus it can be expected to achieve an effect that maintains or increases the bonding strength when the connection part is exposed to a severe high-temperature environment during operation of a device or in an operation environment where switching between on and off of high voltage is performed at a high speed. With regard to Er, it can achieve an effect of improving the high-temperature reliability even when the temperature of the heat treatment during the production of the Al wiring material or the heat treatment after the connection is low. With regard to Yb, it is advantageous in that the time of the heat treatment for precipitation strengthening is shortened since the diffusion speed in Al is high. Gd is advantageous in that the deformability of the Al wiring material at an ordinary temperature can be enhanced and the initial bondability is improved since Gd strongly tends to suppress the hardness of the Al wiring material. Ce and Y are advantageous in that the bonding shape and the size of the wire are stabilized since Ce and Y promote work hardening of a wire in the vicinity of the bonding interface. Addition of a plurality of elements is also effective. For example, when using Sc and Ce or Sc and Yb in combination to coexist, the content can be decreased to enhance the precipitation efficiency. When using Sc and Er in combination to coexist, the temperature of the heat treatment can be decreased. A combination of the second group element is not limited to these combinations. Sc and Gd, Sc and Y, Er and Yb, Er and Gd, Yb and Gd, Yb and Ce, or Ce and Y may be combined, three of these elements may be combined, or four of these elements may be combined.

The Al wiring material of the present invention contains, as the first group element, Mg and Si. The content of Mg is 0.05 to 2.5% by mass, the content of Si is 0.02 to 1% by mass, and the total content of Mg and Si is 0.1 to 3% by mass. That is, it satisfies

$$0.05 \leq x1a \leq 2.5,$$

$$0.02 \leq x1b \leq 1,$$

and

$$0.1 \leq (x1a + x1b) \leq 3$$

where $x1a$ is the content of Mg in the Al wiring material [% by mass] and $x1b$ is the content of Si in the Al wiring material [% by mass].

From the viewpoint of obtaining the Al wiring material with the increased strength during use in a high-temperature environment and a favorable high-temperature reliability, the content of Mg in the Al wiring material, i.e., $x1a$ is 0.05% by mass or more, preferably 0.06% by mass or more, 0.08% by mass or more or 0.09% by mass or more, and more preferably 0.1% by mass or more, 0.15% by mass or more, 0.2% by mass or more, 0.25% by mass or more or 0.3% by mass or more. Provided that the values of x1b, (x1a + x1b), and x2 fall within the ranges of the present invention, when x1a is 0.1% by mass or more, it has been confirmed that the Al wiring material having much better high-temperature properties can be achieved.

From the viewpoint of obtaining the Al wiring material with favorable ordinary temperature properties such as the workability and the bondability during installation and connection to a member to be connected, the upper limit of the content of Mg in the Al wiring material, i.e., x1a is 2.5% by mass or less, preferably 2.4% by mass or less, 2.3% by mass or less, 2.2% by mass or less or 2.1% by mass or less, and more preferably 2% by mass or less, 1.9% by mass or less, 1.8% by mass or less, 1.6% by mass or less or 1.5% by mass or less. Provided that the values of x1b, (x1a + x1b), and x2 fall within the ranges of the present invention, when x1a is 2% by mass or less, it has been confirmed that the Al wiring material exhibiting a high effective bond area ratio and much better ordinary temperature properties can be achieved.

Accordingly, in a preferred embodiment, the content of Mg in the Al wiring material, i.e., x1a satisfies $0.05 \leq$ x1a $\leq 2.5$, and more preferably $0.1 \leq$ x1a $\leq 2$.

From the viewpoint of obtaining the Al wiring material with the increased strength during use in a high-temperature environment and a favorable high-temperature reliability, the content of Si in the Al wiring material, i.e., x1b is 0.02% by mass or more, preferably 0.03% by mass or more or 0.04% by mass or more, and more preferably 0.05% by mass or more, 0.06% by mass or more, 0.08% by mass or more or 0.1% by mass or more. Provided that the values of x1a, (x1a + x1b), and x2 fall within the ranges of the present invention, when x1b is 0.05% by mass or more, it has been confirmed that the Al wiring material having much better high-temperature properties can be achieved.

From the viewpoint of obtaining the Al wiring material with favorable ordinary temperature properties such as the workability and the bondability during installation and connection to a member to be connected, the upper limit of the content of Si in the Al wiring material, i.e., x1b is 1% by mass or less, preferably 0.95% by mass or less, 0.9% by mass or less or 0.85% by mass or less, and more preferably 0.8% by mass or less, 0.75% by mass or less, 0.7% by mass or less, 0.65% by mass or less or 0.6% by mass or less. Provided that the values of x1a, (x1a + x1b), and x2 fall within the ranges of the present invention, when x1b is 0.8% by mass or less, it has been confirmed that the Al wiring material exhibiting a high effective bond area ratio and much better ordinary temperature properties can be achieved.

Accordingly, in a preferred embodiment, the content of Si in the Al wiring material, i.e., x1b satisfies $0.02 \leq$ x1b $\leq 1$, and more preferably $0.05 \leq$ x1b $\leq 0.8$.

From the viewpoint of obtaining the Al wiring material with the increased strength during use in a high-temperature environment and a favorable high-temperature reliability, the total content of Mg and Si in the Al wiring material, i.e., (x1a + x1b) is 0.1% by mass or more, preferably 0.12% by mass or more, 0.14% by mass or more, 0.16% by mass or more or 0.18% by mass or more, and more preferably 0.2% by mass or more, 0.25% by mass or more, 0.3% by mass or more, 0.35% by mass or more or 0.4% by mass or more. Provided that the values of x1a, x1b, and x2 fall within the ranges of the present invention, when (x1a + x1b) is 0.2% by mass or more, it has been confirmed that the Al wiring material having much better high-temperature properties can be achieved.

From the viewpoint of obtaining the Al wiring material with favorable ordinary temperature properties such as the workability and the bondability during installation and connection to a member to be connected, the upper limit of the total content of Mg and Si in the Al wiring material, i.e., (x1a + x1b), is 3% by mass or less, preferably 2.9% by mass or less, 2.8% by mass or less, 2.7% by mass or less or 2.6% by mass or less, and more preferably 2.5% by mass or less, 2.4% by mass or less, 2.3% by mass or less, 2.2% by mass or less, 2.1% by mass or less or 2% by mass or less. Provided that the values of x1a, x1b, and x2 fall within the ranges of the present invention, when (x1a + x1b) is 2.5% by mass or less, it has been confirmed that the Al wiring material exhibiting a high effective bond area ratio and much better ordinary temperature properties can be achieved.

Accordingly, in a preferred embodiment, the total content of Mg and Si in the Al wiring material, i.e., (x1a + x1b) satisfies $0.1 \leq$ (x1a + x1b) $\leq 3$, and more preferably $0.2 \leq$ (x1a + x1b) $\leq 2.5$.

The Al wiring material of the present invention contains, as a second group element, one or more selected from the group consisting of Sc, Er, Yb, Gd, Ce and Y in a total amount of 0.001 to 0.5% by mass. That is, it preferably satisfies $0.001 \leq$ x2 $\leq 0.5$ where x2 is a total content of the second group elements in the Al wiring material [% by mass].

From the viewpoint of obtaining the Al wiring material with the increased strength during use in a high-temperature environment and a favorable high-temperature reliability, the total content of the second group elements in the Al wiring material, i.e., x2 is 0.001% by mass or more, preferably 0.002% by mass or more, 0.003% by mass or more or 0.004% by mass or more, and more preferably 0.005% by mass or more, 0.006% by mass or more, 0.008% by mass or more, 0.01% by mass or more, 0.015% by mass or more, 0.02% by mass or more, 0.025% by mass or more or 0.03% by mass or more. Provided that the values of x1a, x1b, and (x1a + x1b) fall within the ranges of the present invention, when x2 is 0.005% by mass or more, it has been confirmed that the Al wiring material having much better high-temperature properties can be achieved.

From the viewpoint of obtaining the Al wiring material with favorable ordinary temperature properties such as the workability and the bondability during installation and connection to a member to be connected, the upper limit of the total content of the second group elements in the Al wiring material, i.e., x2 is 0.5% by mass or less, preferably 0.48% by mass or less or 0.46% by mass or less, and more preferably 0.45% by mass or less, 0.44% by mass or less, 0.42% by mass or less, 0.4% by mass or less, 0.38% by mass or less, 0.36% by mass or less, 0.35% by mass or less, 0.34% by mass or less, 0.32% by mass or less or 0.3% by mass or less. Provided that the values of x1a, x1b, and (x1a + x1b) fall within the ranges of the present invention, when x2 is 0.35% by mass or less, it has been confirmed that the Al wiring material exhibiting a high effective bond area ratio and much better ordinary temperature properties can be achieved.

Accordingly, in a preferred embodiment, the total content of the second group elements in the Al wiring material, i.e., x2 satisfies $0.001 \leq x2 \leq 0.5$, and more preferably $0.005 \leq x2 \leq 0.35$.

- Zr, Fe, Ni, Mn, Cu, Zn (third group element) -

The Al wiring material of the present invention may further contain one or more selected from the group consisting of Zr, Fe, Ni, Mn, Cu and Zn.

When the Al wiring material contains, in addition to the first group element and the second group element, one or more selected from the group consisting of Zr, Fe, Ni, Mn, Cu and Zn (also referred to as "third group element"), it is possible to achieve the Al wiring material with the increased strength during use in a high-temperature environment and a favorable high-temperature reliability even when the heat treatment during the production of the Al wiring material is performed at a lower temperature or in a shorter time. By shortening the heat treatment time, it is possible to improve the productivity and achieve a continuous operation during the production of the Al wiring material. As a further remarkable effect, even when a post-bonding heat treatment that is a heat treatment after connecting the Al wiring material is performed at a lower temperature and in a shorter time, or even when the post-bonding heat treatment is not performed, it is possible to achieve the Al wiring material having a favorable high-temperature reliability. Therefore, the load on the mounting process due to the post-bonding heat treatment can be reduced, and the thermal history of the member to be connected and peripheral members can be reduced, and as a result, the high-temperature reliability can be further improved.

As for the heat treatment conditions during the production of the Al wiring material, it is possible to shorten the treatment time to 1 second to 10 minutes in a temperature range of 400 to 600°C. As for the conditions of the post-bonding heat treatment after connecting the Al wiring material, it is possible to shorten the treatment time to 10 to 30 minutes at a low-temperature range of 175 to 250°C. For example, when the post-bonding heat treatment is performed at a low temperature of 175°C after the connection, it has been confirmed that a short heat treatment of about 20 minutes suppresses a decrease in the bonding strength in a power cycle test and achieves a favorable high-temperature reliability. Also, depending on the mounting structure and the materials of the electrodes and substrates, it is possible to achieve a favorable high-temperature reliability even if the post-bonding heat treatment is not performed.

As for the synergistic effect achieved by adding the third group elements of Zr, Fe, Ni, Mn, Cu and Zn, in addition to the first group element and the second group element, it is considered that coarsening of crystal grains at a high temperature is suppressed by promoting the formation of intermediate phases and the precipitation of intermetallic compounds in the Mg-Si system described above, and further by promoting the diffusion of Sc, Er, Yb, Gd, Ce and Y, which are the second group elements, to form fine precipitates ($Al_3Sc$, $Al_3Er$, $Al_3Yb$, $Al_3Gd$, etc.).

The Al wiring material of the present invention preferably contains, as the third group element, one or more selected from the group consisting of Zr, Fe, Ni, Mn, Cu and Zn in a total amount of 0.01 to 0.5% by mass. That is, it satisfies $0.01 \leq x3 \leq 0.5$ where x3 is the total content of the third group elements in the Al wiring material [% by mass].

From the viewpoint of obtaining the Al wiring material with enhanced strength during use in a high-temperature environment and a favorable high-temperature reliability even when a heat treatment during the production of the Al wiring material or a heat treatment after the connection is performed at a low temperature or in a short time, the total content of the third group elements in the Al wiring material, i.e., x3 is preferably 0.01% by mass or more, and more preferably 0.02% by mass or more, 0.03% by mass or more or 0.04% by mass or more, and further preferably 0.05% by mass or more, 0.06% by mass or more, 0.08% by mass or more or 0.1% by mass or more. Provided that the values of x1a, x1b, and (x1a + x1b) fall within the ranges of the present invention, when x3 is 0.05% by mass or more, it has been confirmed that the Al wiring material with favorable high-temperature properties can be achieved even when a heat treatment during the production of the Al wiring material or a heat treatment after the connection is performed at a lower temperature or in a shorter time.

From the viewpoint of obtaining the Al wiring material with favorable ordinary temperature properties such as the workability and the bondability during installation and connection to a member to be connected, the upper limit of the total content of the third group elements in the Al wiring material, i.e., x3 is preferably 0.5% by mass or less, more preferably 0.45% by mass or less, and further preferably 0.4% by mass or less, 0.38% by mass or less, 0.36% by mass or less, 0.35% by mass or less, 0.34% by mass or less, 0.32% by mass or less or 0.3% by mass or less. Provided that the values of x1a, x1b, and (x1a + x1b) fall within the ranges of the present invention, when x3 is 0.4% by mass or less, it has been confirmed that the Al wiring material exhibiting a high effective bond area ratio and much better ordinary temperature properties can be achieved.

Accordingly, in a preferred embodiment, the total content of the third group elements in the Al wiring material, i.e., x3 satisfies $0.01 \leq x3 \leq 0.5$, and more preferably $0.05 \leq x3 \leq 0.4$.

The balance, the remaining part, of the Al wiring material according to the present invention contains Al. As an aluminum raw material for manufacturing the Al wiring material, an industrially pure Al having a purity of 4N (Al: 99.99% by mass or more) can be used. More preferably, aluminum having a purity equal to or higher than 5N (Al: 99.999% by mass or more) is used. In a range of not inhibiting the effect of the present invention, the balance of the Al wiring material according to the present invention may contain an element other than Al. The content of Al in the balance of the Al wiring material according to the present invention is not limited so long as the content does not inhibit the effect of the present invention, and is preferably 98% by mass or more, 98.5% by mass or more, 99% by mass or more, 99.5% by mass or more, 99.6% by mass or more, 99.7% by mass or more, 99.8% by mass or more, or 99.9% by mass or more. According to a preferred embodiment, the balance of the Al wiring material of the present invention consists of Al and inevitable impurities.

The contents of the first group element, the second group element, the third group element, and the like in the Al wiring material can be measured by using the method in [Measurement of element content] described later.

The Al wiring material of the present invention may have a coating that contains a metal other than Al as a main component on an outer periphery of the Al wiring material, or does not necessarily have the coating. In a preferred embodiment, the Al wiring material of the present invention does not have a coating that contains a metal other than Al as a main component on the outer periphery of the Al wiring material. Herein, the "coating that contains a metal other than Al as a main component" means the coating in which the content of the metal other than Al is 50% by mass or more.

The Al wiring material of the present invention can maintain and/or improve the strength during use in a high-temperature environment and exhibit a favorable high-temperature reliability by performing a low-temperature or short-time treatment for the heat treatment during the production of the Al wiring material or the heat treatment after the connection or without requiring the heat treatment. The Al wiring material of the present invention can also enhance ordinary temperature properties such as the workability and the bondability during installation and connection to a device. Therefore, the Al wiring material of the present invention can be used in wide applications that require both of the high-temperature reliability and the ordinary temperature properties at the time of connection to a member to be connected. For example, the Al wiring material can be suitably used for connection to a member to be connected in industrial devices such as a conveying device and a robot (Al wiring material for industrial devices). The Al wiring material can be suitably used for connection to a member to be connected in various semiconductor devices including a power semiconductor device (Al wiring material for semiconductor devices).

The Al wiring material of the present invention may have an arbitrary size depending on a specific aspect of use. In a case where the Al wiring material of the present invention is an Al wire used for industrial devices such as a conveying device and a robot, the diameter of the Al wire is not particularly limited and may be 500 $\mu$m to 10 mm, for example. The Al wiring material may be a stranded wire formed from a plurality of Al wires. In a case where the Al wiring material is an Al strip, the dimensions (w $\times$ t) of a rectangular or substantially rectangular cross section thereof are not particularly limited, and w may be 500 $\mu$m to 10 mm, and t may be 50 $\mu$m to 2 mm, for example. In a case where the Al wiring material of the present invention is an Al bonding wire used for various semiconductor devices including a power semiconductor device, the diameter of the Al bonding wire is not particularly limited and may be 50 to 600 $\mu$m, for example. In a case where the Al wiring material is an Al bonding ribbon, the dimensions (w $\times$ t) of a rectangular or substantially rectangular cross section thereof are not particularly limited, and w may be 100 to 3,000 $\mu$m, and t may be 50 to 600 $\mu$m, for example.

A manufacturing method for the Al wiring material of the present invention is not particularly limited. For example, the Al wiring material of the present invention may be manufactured by using a known processing method such as extrusion processing, swaging processing, wire-drawing processing, and rolling processing, for example. When the wire diameter is small to some extent, it is preferable that wire-drawing processing with diamond dies is performed. With regard to the cold working in which the wire-drawing is performed at an ordinary temperature, a production device and the like therefor have a relatively simple configuration and a workability thereof is excellent. When the resistance during wire-drawing is decreased so as to increase the productivity, there may be used the hot working in which the wire-drawing is performed while heating.

After weighing pure metals of Al and additive elements as starting materials so that the content of each additive element falls within a specific range, these materials are mixed and then molten and solidified to form an ingot. Alternatively, as the raw material for each additive element, a mother alloy containing the additive element in high concentration may be used. In the process of melting for producing the ingot, a batch process or a continuous casting process can be used. The continuous casting process has an excellent productivity, and the batch process is easy to change a cooling temperature condition for solidification. The Al wiring material can be formed by processing the ingot to have final dimensions.

In order to make each additive element into a solid solution so as to be uniformly distributed, it is preferable to perform a solution heat treatment in a state of the ingot, in the middle of processing or after the processing end. In the solution heat treatment, the additive elements are dissolved in Al at a high temperature at which solid solubility is high. Then, the resultant is cooled to an ordinary temperature at increased cooling rate by water cooling, air cooling, or the like in order to suppress the precipitation of the dissolved elements. The solution heat treatment may be performed, for example, by heating at a temperature range of 500 to 640°C for 0.5 hours to 20 hours, followed by cooling with water cooling, air cooling, or the like. When performing a heat treatment at a high temperature at which the solubility is high, a precipitate that has been generated during solidification of the ingot may be redissolved so as to achieve a state in which the additive elements are uniformly distributed. When a mother alloy containing the additive element in high concentration is used, the solid solution state is easily controlled. Therefore, a heating time can be set to be short. Further, the solution heat treatment can be substituted by increasing the cooling rate during solidification. For example, in the continuous casting process, the solidification rate can be increased as compared to the solidification in the batch solution process, and thus the additive elements are relatively easily dissolved in Al. Therefore, when using the continuous casting process, the solution heat treatment may not be performed.

In order to promote the precipitation in an Al alloy that has been subjected to the solution heat treatment, the precipitation heat treatment may be performed. The precipitation heat treatment can be performed immediately after melt-solidification or the solution heat treatment, in the middle of subsequent processing or after the processing end. For progress of formation of a precipitate, it is desirable that the heat treatment condition is optimized to obtain predetermined mechanical properties.

When subjecting to the precipitation heat treatment in a state of large wire diameter by a batch process, the precipitation heat treatment may be performed, for example, by heating at a temperature range of 200 to 450°C for 10 minutes to 5 hours. Specific examples of the conditions may include a condition of 250°C for 3 hours and a condition of 350°C for 30 minutes. Alternatively, when subjecting to the precipitation heat treatment in a state of processed small wire diameter by a continuous manner, the precipitation heat treatment may be performed, for example, by heating the wire at a temperature range of 400 to 600°C for 1 second to 5 minutes. Specifically, the condition may be 400°C for 1 second for suppressing the development of precipitation, and may be 500°C for 40 seconds for promoting the formation of the precipitate, for example. In order to optimize the conditions more precisely, the temperature, the time, and the like can be easily optimized by an isothermal heat treatment or an isochronal heat treatment referring to the above heat treatment conditions. For example, when Al wiring materials subjected to an isothermal heat treatment under several time conditions are prototyped and mechanical properties thereof are measured, desired properties can be easily reproduced.

In the middle of processing the Al wiring material or in the final diameter of the Al wiring material, the Al wiring material may be subjected to a thermal refining heat treatment. By performing the thermal refining heat treatment, the working strain is removed, and a recrystallized structure is formed, and also the precipitation can be formed. In this thermal refining heat treatment, it is preferable that the heat treatment is continuously performed while the Al wiring material is continuously swept in a heating furnace. Examples of this heat treatment condition may include heating at a temperature range of 300 to 600°C for a short time of 0.1 seconds to 2 minutes. By performing the thermal refining heat treatment, precipitation can be proceeded. Therefore, the thermal refining heat treatment can simultaneously serve also as the precipitation heat treatment depending on a necessary degree of precipitation.

Regarding connection between the Al wiring material of the present invention and the member to be connected in a semiconductor device, both of the first connection with an electrode on a semiconductor chip and the second connection with a lead frame or an external electrode on a substrate are performed by wedge bonding. After connection with the member to be connected, the semiconductor device including the Al wiring material may be subjected to a post-bonding heat treatment. By performing the post-bonding heat treatment, a precipitate which is an intermetallic compound containing the additive elements is formed in the Al wiring material, and thus, the strength can be further increased by precipitation strengthening. In the Al wiring material of the present invention, the chemical composition and type of the formed precipitate are as described above.

A condition for the post-bonding heat treatment is not particularly limited as long as the intermetallic compound can be formed. For example, the post-bonding heat treatment is preferably performed at a temperature range of 175 to 400°C for 10 to 60 minutes. An atmosphere during the post-bonding heat treatment may be the atmospheric air, or may be an inert atmosphere such as nitrogen and argon for suppression of oxidation of members.

The present invention also provides a manufacturing method for the semiconductor device. In a preferred embodiment, the manufacturing method for the semiconductor device of the present invention includes:

(A) a step of connecting the electrode on the semiconductor chip to the lead frame or the electrode on the substrate via the Al wiring material of the present invention; and
(B) a step of performing the post-bonding heat treatment after the connection via the Al wiring material.

For the semiconductor chip, the lead frame, or the substrate used at the step (A), known components that may be used for constituting the semiconductor device may be used as described later. Details and preferred aspects of the Al wiring material of the present invention used at the step (A) are as described above. At the step (A), both of the first connection with the electrode on the semiconductor chip and the second connection with the lead frame or the electrode on the substrate may be performed by wedge bonding. In the step (B), the fine precipitate phase of the intermetallic compound described above can be formed in the Al wiring material.

[Semiconductor Device]

The semiconductor device can be manufactured by connecting the electrode on the semiconductor chip to the lead frame or the electrode on the substrate by using the Al wiring material of the present invention.

The semiconductor device of the present invention includes the Al wiring material of the present invention. The Al wiring material of the present invention can enhance the workability and bondability during installation and connection to the device. In addition, by performing a low-temperature or short-time treatment for the heat treatment during production of the wiring material or the heat treatment after connection or without requiring the heat treatment, a favorable high-temperature reliability can be exhibited. Therefore, the semiconductor device including the Al wiring material can achieve a favorable operation reliability for a long time even in a high-temperature operation environment, as well as can decrease a thermal influence on a member to be connected. Accordingly, the semiconductor device including the Al wiring material of the present invention comprehensively satisfy many required performances.

In one embodiment, the semiconductor device of the present invention includes the circuit board, the semiconductor chip, and the Al wiring material for bringing the circuit board and the semiconductor chip into conduction with each other, and is characterized in that the Al wiring material is the Al wiring material of the present invention. It should be noted that the "Al wiring material of the present invention" related to the semiconductor device of the present invention is characterized by containing the first group element and the second group element, and as necessary, the third group element in the preferred concentration ranges described above.

In the semiconductor device of the present invention, the fine phase of the precipitate separated from Al (for example, a precipitate of the above-described intermetallic compound containing the additive elements) can be maintained as it is even when the semiconductor device is operated for a long time in a high-temperature environment.

In the semiconductor device of the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in JP-A-2020-150116 and JP-A-2002-246542, the semiconductor device may include a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

**Examples**

Hereinafter, the present invention will be described in detail with reference to Examples. However, the present invention is not limited to the following Examples.

(Sample)

A method for producing a sample will be described. Al having a purity of 5 N (99.999% by mass or more), and Mg, Si, Sc, Er, Yb, Gd, Ce, Y, Zr, Fe, Ni, Mn, Cu and Zn having a purity of 99.9% by mass or more were molten as raw materials, and an Al ingot having each composition indicated in Tables 1 and 2 was prepared. Subsequently, the ingot was subjected to a solid solution heat treatment at a range of 550 to 640°C for 5 hours, and quenched (water-cooled). The ingot was then subjected to an extrusion process, a swaging process, followed by a wire-drawing process. Some of the samples were subjected to a precipitation heat treatment at a range of 300 to 500°C for 1 to 30 minutes at a stage where the wire diameter was 2 mm. Next, the samples were each wire drawn with dies such that the final wire diameter was 300 $\mu$m. Thereafter, a wire-drawing process using dies was performed to achieve a final wire diameter of 300 $\mu$m. After the wire-drawing processing ended, thermal refining heat treatment was performed in a heat treatment time of 2 seconds, and thus obtaining the Al wiring material.

[Measurement of element content]

The content of additive elements in the Al wiring material was measured by using ICP-OES ("PS3520UVDDII" manufactured by Hitachi High-Tech Corporation) or ICP-MS ("Agilent 7700x ICP-MS" manufactured by Agilent Technologies, Inc.) as an analysis device.

<Connection>

In the semiconductor device, the electrode on the semiconductor chip was an Al-Cu pad (thickness: 2 $\mu$m), and an Ni-coated Cu lead frame was used for an external terminal. A first connection part between the electrode on the semiconductor chip and the Al wiring material, and a second connection part between the external terminal and the Al wiring material were both wedge-bonded. In each Examples, a post-bonding heat treatment was performed under the condition of (1) at 200°C for 30 minutes or (2) at 175°C for 30 minutes.

<Evaluation of Bondability>

- Bonding Strength -

As for the bonding strength of the Al wiring material in the semiconductor device, the initial shear force $S1$ of the first connection part (before the power cycle test) was measured (the number of evaluations N = 20). In the "Bonding strength" column of Tables 1 and 2, a case in which the value $S1$ was 9 N or more was marked with a symbol of "circle" since the bonding strength was good, a case in which it was 7 N or more and less than 9 N was marked with a symbol of "triangle" since the bonding strength had no problem for normal use, but it was necessary to pay attention, and a case in which it was less than 7 N was marked with a symbol of "cross" since the bondability was inferior.

- Effective Bond Area Ratio -

For the effective bond area ratio ($R$) of the Al wiring material in the semiconductor device, the fractured bonded part in the first connection part in which the shear strength $S1$ had been measured was observed with an optical microscope or a SEM. By image analysis, a bond area $M1$ and an unbonded area $M3$ which was determined that the electrode was deformed at the time of bonding but a metal junction was not achieved were determined, and an achieved metal junction $M2$ (= $M1 - M3$) was calculated. The value $R$ was calculated as the ratio ($M2/M1$) of $M2$ to $M1$. In a column "Effective bond area ratio" column of Tables 1 and 2, a case in which the $R$ value was 0.9 or more was marked with a symbol of "circle" since the bondability was favorable, a case in which it was 0.7 or more and less than 0.9 was marked with a symbol of "triangle" since the bondability had no problem for normal use, but it was necessary to pay attention, and a case in which it was less than 0.7 was marked with a symbol of "cross" since the bondability was inferior.

- Chip Damage -

A chip damage in the semiconductor device was evaluated by dissolving metal on a pad surface by acid, and observing a part under the pad by a microscope (the number of evaluations N = 50). In the "chip damage" column of Tables 1 and 2, a case in which a crack, traces of bonding and the like were not found was determined to be favorable to be marked with a symbol of "circle", a case in which there was no crack but traces of bonding were found at some spots (three spots or less of the number of evaluations 50) was marked with a symbol of "triangle", and other cases were marked with a symbol of "cross".

<Evaluation of high-temperature reliability>

The high-temperature reliability was evaluated by a power cycle test. In the power cycle test, heating and cooling were alternately and repeatedly performed for the semiconductor device in which the Al wiring material was connected. The heating was performed for 2 seconds until the maximum temperature reached about 140°C, and the cooling was performed for 25 seconds until the temperature of the connection part reached 30°C thereafter. This heating-cooling cycle was repeated. The semiconductor device that had been subjected to the post-bonding heat treatment at 200°C for 30 minutes was subjected to the above described cycle of 50,000 times and 100,000 times, and evaluated. The semiconductor device that had been subjected to the post-bonding heat treatment at 175°C for 30 minutes was subjected to the above described cycle of 50,000 times, and evaluated.

The high-temperature reliability of the connection part was evaluated by measuring the bond shear force of the first connection part after the power cycle test. The high-temperature reliability was evaluated by a ratio $S2/S1$ where the initial shear force of the connection part was S1 and the shear force after the power cycle test was S2. In the "High-temperature reliability of connection part" column of Tables 1 and 2, a case in which the ratio S2/S1 was 0.9 or more was marked with a symbol of "double circle" since the reliability was excellent, a case in which the ratio S2/S1 was 0.8 or more and less than 0.9 was marked with a symbol of "circle" since the reliability was favorable, a case in which the ratio S2/S1 was 0.6 or more and less than 0.8 was marked with a symbol of "triangle" since the reliability had no problem for normal use, but it was necessary to pay attention, and a case in which the ratio S2/S1 was less than 0.6 was marked with a symbol of "cross" since the high-temperature reliability was inferior.

The production conditions of the Al wiring materials and the evaluation results are shown in Tables 1 and 2.

(Table 1)

| | | First group element (% by mass) | | | Second group element (% by mass) | | | | | | Third group element (% by mass) | | | | | | Heat treament of Al wiring material | | High-temperature reliability of connection part | | | Bondability | | |
|---|---|---|---|---|---|---|---|---|---|---|---|---|---|---|---|---|---|---|---|---|---|---|---|---|
| | | | | | | | | | | | | | | | | | Solution heat treatment (°C) | Precipitation heat treatment (°C) | 50,000 times | 100,000 times | 50,000 times | Bonding strength | Effective bond area ratio | Chip damage |
| | | Mg | Si | Mg+Si | Sc | Er | Yb | Gd | Ce | Y | Zr | Fe | Ni | Mn | Cu | Zn | | | Post-bonding heat treatment 200°C–30min | | Post-bonding heat treatment 175°C–30min | | | |
| Working Example | 1 | 0.1 | 0.1 | 0.2 | 0.005 | | | | | | | | | | | | 580 | 300 | ◎ | ◎ | ○ | ○ | ○ | ○ |
| | 2 | 0.2 | 0.1 | 0.3 | 0.001 | | | | | | | 0.03 | 0.005 | | | | 620 | — | ◎ | ○ | ◎ | ○ | ○ | ○ |
| | 3 | 0.5 | 0.5 | 1.0 | 0.02 | | | | | | 0.03 | | | | | | 620 | 400 | ◎ | ◎ | ◎ | ○ | ○ | ○ |
| | 4 | 1.2 | 0.7 | 1.9 | 0.3 | | | | | | 0.1 | | | | | | 620 | 420 | ◎ | ◎ | ◎ | ○ | ○ | ○ |
| | 5 | 2.0 | 1.0 | 3.0 | 0.1 | | | | | | | | | | | | 620 | 450 | ◎ | ◎ | ○ | △ | ○ | ○ |
| | 6 | 0.5 | 0.4 | 0.9 | 0.1 | | | | | | | | 0.005 | 0.3 | | | 600 | 330 | ◎ | ◎ | ◎ | ○ | ○ | ○ |
| | 7 | 0.6 | 0.1 | 0.7 | 0.05 | | | | | | | | | | | 0.3 | 620 | 300 | ◎ | ◎ | ◎ | ○ | ○ | ○ |
| | 8 | 0.1 | 0.06 | 0.16 | | 0.003 | | | | | | | 0.01 | | | | 620 | 350 | ◎ | ○ | ◎ | ○ | ○ | ○ |
| | 9 | 0.14 | 0.2 | 0.34 | | 0.06 | | | | | 0.05 | | | | | | 600 | 400 | ◎ | ◎ | ◎ | ○ | ○ | ○ |
| | 10 | 0.6 | 0.4 | 1.0 | | 0.3 | | | | | | 0.1 | | 0.1 | | | — | 400 | ◎ | ◎ | ◎ | ○ | ○ | ○ |
| | 11 | 1.2 | 0.7 | 1.9 | | 0.1 | | | | | | | | | | | 600 | 400 | ◎ | ◎ | ○ | ○ | ○ | ○ |
| | 12 | 0.5 | 0.5 | 1.0 | | 0.2 | | | | | | | | | 0.1 | 0.25 | 580 | 400 | ◎ | ◎ | ◎ | ○ | ○ | ○ |
| | 13 | 0.12 | 0.05 | 0.17 | | | 0.06 | | | | | | | | | | 620 | — | ◎ | ◎ | ○ | ○ | ○ | ○ |
| | 14 | 0.3 | 0.4 | 0.7 | | | 0.003 | | | | | 0.2 | | 0.3 | | | 550 | 450 | ◎ | ◎ | ◎ | ○ | ○ | ○ |
| | 15 | 1.2 | 0.7 | 1.9 | | | 0.2 | | | | 0.01 | | | | | | 600 | 400 | ◎ | ◎ | ◎ | ○ | ○ | ○ |
| | 16 | 0.2 | 0.3 | 0.5 | | | 0.1 | | | | | 0.4 | | | | 0.1 | 600 | 330 | ◎ | ◎ | ◎ | ○ | ○ | ○ |
| | 17 | 0.1 | 0.1 | 0.2 | | | | 0.03 | | | | | | | | | — | 500 | ◎ | ◎ | ○ | ○ | ○ | ○ |
| | 18 | 0.4 | 0.3 | 0.7 | | | | 0.1 | | | 0.05 | | | | | | 620 | 400 | ◎ | ◎ | ◎ | ○ | ○ | ○ |
| | 19 | 1.2 | 0.7 | 1.9 | | | | 0.004 | | | | | 0.02 | | | | 620 | 300 | ◎ | ○ | ◎ | ○ | ○ | ○ |
| | 20 | 1.1 | 0.5 | 1.6 | | | | | 0.03 | | | | 0.04 | | | | 600 | 500 | ◎ | ◎ | ◎ | ○ | ○ | ○ |
| | 21 | 0.5 | 0.5 | 1.0 | | | | | 0.1 | | | 0.3 | | | 0.1 | | 600 | 400 | ◎ | ◎ | ◎ | ○ | ○ | ○ |
| | 22 | 0.2 | 0.2 | 0.4 | | | | | 0.3 | | | | | 0.2 | | 0.2 | 600 | 300 | ◎ | ◎ | ◎ | ○ | ○ | ○ |
| | 23 | 0.4 | 0.2 | 0.6 | | | | | | 0.05 | 0.08 | | | | 0.3 | | 600 | 350 | ◎ | ◎ | ◎ | ○ | ○ | ○ |
| | 24 | 0.4 | 0.5 | 0.9 | | | | | | 0.1 | | 0.4 | | | | | 600 | 300 | ◎ | ◎ | ◎ | ○ | ○ | ○ |
| | 25 | 0.8 | 0.4 | 1.2 | | | | | | 0.2 | | | 0.03 | | | 0.1 | 600 | 300 | ◎ | ◎ | ◎ | ○ | ○ | ○ |

[Table 2]

(Table 2)

| | No. | First group element (% by mass) | | | Second group element (% by mass) | | | | | | Third group element (% by mass) | | | | | | Heat treatment of Al wiring material | | High-temperature reliability of connection part | | | Bondability | | |
|---|---|---|---|---|---|---|---|---|---|---|---|---|---|---|---|---|---|---|---|---|---|---|---|---|
| | | Mg | Si | Mg+Si | Sc | Er | Yb | Gd | Ce | Y | Zr | Fe | Ni | Mn | Cu | Zn | Solution heat treatment (°C) | Precipitation heat treatment (°C) | Post-bonding heat treatment 200°C-30min 50,000 times | Post-bonding heat treatment 200°C-30min 100,000 times | Post-bonding heat treatment 175°C-30min 50,000 times | Bonding strength | Effective bond area ratio | Chip damage |
| Working Example | 26 | 0.05 | 0.05 | 0.1 | 0.03 | 0.02 | | | | | | | | | | | 620 | 400 | ◎ | ○ | ○ | ○ | ○ | ○ |
| | 27 | 0.15 | 0.02 | 0.17 | 0.001 | | 0.001 | | | | 0.05 | | | | | | 620 | 300 | ◎ | ◎ | ◎ | ○ | ○ | ○ |
| | 28 | 0.4 | 0.5 | 0.9 | | 0.2 | 0.2 | 0.2 | | | | 0.4 | | | | | 640 | 450 | ◎ | ◎ | ◎ | ○ | △ | ○ |
| | 29 | 1.0 | 0.6 | 1.6 | 0.03 | 0.2 | 0.1 | 0.2 | | | | | | | | | 640 | 400 | ◎ | ◎ | ○ | △ | △ | △ |
| | 30 | 2.5 | 0.5 | 3.0 | | | | | | | | | | | | | 640 | 400 | ◎ | ◎ | ◎ | ○ | △ | ○ |
| | 31 | 0.3 | 0.2 | 0.5 | 0.1 | | | 0.02 | 0.1 | | | 0.2 | 0.06 | 0.3 | | | 620 | 350 | ◎ | ◎ | ◎ | ○ | ○ | ○ |
| | 32 | 0.6 | 0.6 | 1.2 | | | | 0.05 | | 0.1 | | 0.3 | 0.03 | | | 0.05 | 620 | 400 | ◎ | ◎ | ◎ | ○ | ○ | ○ |
| | 33 | 0.5 | 0.5 | 1.0 | | | | | 0.2 | 0.1 | | | | | 0.2 | 0.1 | 640 | 400 | ◎ | ◎ | ○ | ○ | △ | ○ |
| Comparative Example | 1 | 0.2 | 0.2 | 0.4 | | | | | | | | | | | | | 640 | 300 | × | × | × | △ | △ | ○ |
| | 2 | 0.3 | 0.2 | 0.5 | | | | | | | | | | | | | 640 | 400 | × | × | × | △ | △ | ○ |
| | 3 | 0.1 | 0.1 | 0.2 | | | | | | | 0.1 | | | | | | 640 | 400 | × | × | × | △ | △ | ○ |
| | 4 | 0.06 | 0.03 | 0.09 | | 0.03 | 0.03 | | | | | | | | | | 640 | 400 | × | × | × | △ | △ | ○ |
| | 5 | 0.18 | 0.01 | 0.19 | | 0.02 | | | | | | | 0.1 | 0.1 | | | 640 | 400 | △ | × | × | × | × | × |
| | 6 | 2.4 | 0.7 | 3.1 | | 0.02 | | | | | | | | | | | 640 | 400 | × | × | × | △ | × | × |
| | 7 | 1.0 | 1.1 | 2.1 | 0.08 | | | | | | | 0.1 | | 0.1 | | | 640 | 400 | △ | × | × | ○ | ○ | ○ |
| | 8 | 0.4 | 0.4 | 0.8 | | 0.0005 | 0.0004 | | | | | 0.1 | | | | | 640 | 400 | × | × | × | △ | × | × |
| | 9 | 0.4 | 0.4 | 0.8 | 0.17 | 0.17 | | 0.18 | | | 0.1 | 0.2 | | | | | 640 | 400 | △ | × | × | ○ | ○ | ○ |
| | 10 | | | | 0.02 | 0.01 | | | | | | | | | | | 640 | 400 | × | × | × | △ | × | × |
| | 11 | | | | | | | | | | | | | | | | 640 | 400 | × | × | × | △ | △ | ○ |
| | 12 | | | | 0.1 | | 0.02 | | | | | | | | | | 640 | 400 | × | × | × | △ | △ | ○ |
| | 13 | | | | 0.05 | 0.05 | | 0.2 | | | | | | | | | 640 | 400 | × | × | × | △ | △ | ○ |

For the Al wiring materials in Examples 1 to 33, the contents of Mg and Si and the total contents of Sc, Er, Yb, Gd, Ce and Y was within the range of the present invention, the bondability was favorable regardless of the presence or absence of a heat treatment during production of the wiring materials and after connection as well as the temperature and time thereof. Further, for the Al wiring materials in Examples 1 to 33, the high-temperature reliability (50,000 times) was evaluated to be favorable as marked with a symbol of "double circle".

For the Al wiring materials in Examples 2 to 4, 6 to 10, 12, 14 to 16, 18 to 25, 27, 28, and 30 to 33, the contents of Zr, Fe, Ni, Mn, Cu and Zn were also within the preferred range of the present invention, the high-temperature reliability when the heat treatment after connection (post-bonding heat treatment) was performed at a low temperature of 175°C for 30 minutes was evaluated to be favorable as marked with a symbol of "double circle".

For the Al wiring materials in Comparative Examples 1 to 3, and 8, the contents of Sc, Er, Yb, Gd, Ce and Y were out of the lower limit of the range of the present invention, and the results of the high-temperature reliability of the connection part were inferior as marked with a symbol of "cross". For the Al wiring materials in Comparative Examples 4, 5, and 10 to 13, the contents of Mg and Si (at least one or more of x1a, x1b, and x1a+x1b) were out of the lower limit of the range of the present invention, and the results of the high-temperature reliability of the connection part were inferior as marked with a symbol of "cross". For the Al wiring materials in Comparative Examples 6 and 7, the contents of Mg and Si (at least one or more of x1a, x1b, and x1a+x1b) were out of the upper limit of the range of the present invention, and the results of chip damage were inferior as marked with a symbol of "cross". For the Al wiring material in Comparative Example 9, the contents of Sc, Er, Yb, Gd, Ce and Y were out of the upper limit of the range of the present invention, and the result of chip damage was inferior as marked with a symbol of "cross".

For the Al wiring materials in Examples 1 to 33, it was confirmed that, even when the post-bonding heat treatment was not performed after connection, favorable effects of the high-temperature reliability and the bondability were achieved as compared to Comparative Examples.

## Claims

1. An Al wiring material containing Mg and Si so as to satisfy

$$0.05 \leq x1a \leq 2.5,$$

$$0.02 \leq x1b \leq 1,$$

and

$$0.1 \leq (x1a + x1b) \leq 3$$

where x1a is a content of Mg [% by mass] and x1b is a content of Si [% by mass], and containing one or more selected from the group consisting of Sc, Er, Yb, Gd, Ce and Y so as to satisfy

$$0.001 \leq x2 \leq 0.5$$

where x2 is a total content thereof [% by mass], with the balance comprising Al.

2. The Al wiring material according to claim 1, further containing one or more selected from the group consisting of Zr, Fe, Ni, Mn, Cu and Zn so as to satisfy

$$0.01 \leq x3 \leq 0.5$$

where x3 is a total content thereof [% by mass].

3. The Al wiring material according to claim 1 or 2, wherein the Al wiring material is a bonding wire.

4. A semiconductor device comprising the Al wiring material according to any one of claims 1 to 3.

## INTERNATIONAL SEARCH REPORT

International application No.

**PCT/JP2021/030994**

### A. CLASSIFICATION OF SUBJECT MATTER

***H01L 21/60***(2006.01)i
FI: H01L21/60 301F

According to International Patent Classification (IPC) or to both national classification and IPC

### B. FIELDS SEARCHED

Minimum documentation searched (classification system followed by classification symbols)

H01L21/00; C22C21/00; C22F1/00

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 61-179841 A (FURUKAWA ELECTRIC CO., LTD.) 12 August 1986 (1986-08-12)<br>page 2, lower right column, line 16 to page 3, lower left column, line 2 | 1-4 |
| X | CN 106271192 A (LANZHOU WEITE WELDING TECH CO., LTD.) 04 January 2017 (2017-01-04)<br>paragraph [0010] | 1, 3-4 |
| X | CN 107779702 A (AECC BEIJING INST AERONAUTICAL MAT) 09 March 2018 (2018-03-09)<br>paragraph [0017] | 1, 3-4 |
| X | JP 2-1126 A (HITACHI, LTD.) 05 January 1990 (1990-01-05)<br>page 4, upper left column, lines 3-18 | 1-2, 4 |
| Y | JP 62-96642 A (SUMITOMO ELECTRIC INDUSTRIES, LTD.) 06 May 1987 (1987-05-06)<br>page 3, left column, lines 11-20 | 1-4 |
| Y | JP 2020-59882 A (NIPPON MICROMETAL CORP.) 16 April 2020 (2020-04-16)<br>paragraph [0004] | 1-4 |

☑ Further documents are listed in the continuation of Box C.          ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 October 2021** | **02 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
| --- |
| **PCT/JP2021/030994** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 110340565 A (UNIV SHANGHAI JIAOTONG) 18 October 2019 (2019-10-18) entire text, all drawings | 1-4 |

Form PCT/ISA/210 (second sheet) (January 2015)

INTERNATIONAL SEARCH REPORT
Information on patent family members

International application No.

PCT/JP2021/030994

| Patent document cited in search report | | | Publication date (day/month/year) | Patent family member(s) | Publication date (day/month/year) |
|---|---|---|---|---|---|
| JP | 61-179841 | A | 12 August 1986 | (Family: none) | |
| CN | 106271192 | A | 04 January 2017 | (Family: none) | |
| CN | 107779702 | A | 09 March 2018 | (Family: none) | |
| JP | 2-1126 | A | 05 January 1990 | US 5019891 A page 20, left column, lines 5-20 EP 326018 A2 KR 10-1989-0012377 A | |
| JP | 62-96642 | A | 06 May 1987 | (Family: none) | |
| JP | 2020-59882 | A | 16 April 2020 | (Family: none) | |
| CN | 110340565 | A | 18 October 2019 | (Family: none) | |

Form PCT/ISA/210 (patent family annex) (January 2015)

**REFERENCES CITED IN THE DESCRIPTION**

**Patent documents cited in the description**

- JP 2002314038 A
- JP 2016511529 A
- JP 2014047417 A
- JP 2016152316 A
- JP 6272674 B
- JP 2020150116 A
- JP 2002246542 A